Europäisches Patentamt

European Patent Office

Office européen des brevets

(11) Veröffentlichungsnummer: **0 222 347**

**A2**

## (12) EUROPÄISCHE PATENTANMELDUNG

(21) Anmeldenummer: 86115484.7

(22) Anmeldetag: 07.11.86

(51) Int. Cl.⁴: **C23F 1/16 , C23F 1/08**

(30) Priorität: 11.11.85 DE 3539886

(43) Veröffentlichungstag der Anmeldung:
**20.05.87 Patentblatt 87/21**

(84) Benannte Vertragsstaaten:
**AT BE CH DE FR GB IT LI NL SE**

(71) Anmelder: **HANS HÖLLMÜLLER MASCHINENBAU GMBH & CO.
Kappstrasse 69
D-7033 Herrenberg(DE)**

(72) Erfinder: **Haas, Rainer
Filsstrasse 6
D-7033 Herrenberg(DE)**

(74) Vertreter: **Ostertag, Ulrich et al
Patentanwälte Dr. Ulrich Ostertag Dr.
Reinhard Ostertag Eibenweg 10
D-7000 Stuttgart 70(DE)**

(54) Verfahren und Vorrichtung zum Ätzen eines zumindest teilweise aus Metall, vorzugsweise Kupfer, bestehenden Ätzguts.

(57) Bei einem Verfahren zum Ätzen von Ätzgut, das zumindest teilweise aus Metall besteht, wird eine Säure verwendet, die erst nach Zugabe eines Oxidationsmittels unmittelbar vor dem eigentlichen Ätzvorgang das Metall angreift. Die Zugabe des Oxidationsmittels erfolgt in einer Menge, die geringfügig die stöchiometrisch zur Abtragung des gesamten Metalles erforderliche Menge übersteigt, so daß ein geringer Rest an Oxidationsmittel in dem vom Ätzgut abtropfenden Ätzmittel verbleibt. Dieses restliche Oxidationsmittel wird dann aus dem Ätzmittel durch eine besondere Einrichtung wieder entfernt, welche ein von dem Ätzmittel ätzbares Metall im Überschuß enthält.

EP 0 222 347 A2

# Verfahren und Vorrichtung zum Ätzen eines zumindest teilweise aus Metall, vorzugsweise aus Kupfer, bestehenden Ätzguts

Die Erfindung betrifft ein Verfahren zum Ätzen eines zumindest teilweise aus Metall, vorzugsweise aus Kupfer, bestehenden Ätzguts, vorzugsweise von gedruckten Leiterplatten, mit einem eine Säure, vorzugsweise Schwefelsäure, enthaltenden Ätzmittel, welchem kurz vor dem eigentlichen Ätzvorgang eine bestimmte Menge Oxidationsmittel zugesetzt wird, die in stöchiometrischer Beziehung zur Menge des abzuätzenden Metalles steht.

Die Erfindung betrifft außerdem eine Vorrichtung zur Durchführung dieses Verfahrens mit einer Ätzmaschine, welche eine Vielzahl von Düsen und einen Ätzmittelsumpf umfaßt, mit einer Pumpe, welche dem Ätzmittelsumpf Ätzmittel entnimmt und den Düsen über eine Einrichtung zuführt, in welcher dem Ätzmittel ein Oxidationsmittel beigemischt wird, mit einer Einrichtung, welche die Zugabe des Oxidationsmittels zum Ätzmittel in stöchiometrischer Abhängigkeit von der Menge des abzuätzenden Metalles regelt.

Ein derartiges Verfahren und eine derartige Vorrichtung sind aus der EP-A 00 53 719 bekannt. Hier wird Kupfer mit Schwefelsäure geätzt, der unmittelbar vor dem eigentlichen Ätzvorgang Wasserstoffperoxid zugesetzt wird. Da es bekannt ist, daß Wasserstoffperoxid sich in dem Ätzmittel zersetzt, was beim Umwälzen des Ätzmittels zu Störungen in der Pumpe führen kann, und da außerdem im Ätzmittel vorhandenes Wasserstoffperoxid bei einer elektrolytischen Regeneration des Ätzmittels nachteilig ist, wird in der EP-A 00 53 719 angestrebt, das Wasserstoffperoxid genau in der Menge zuzugeben, die stöchiometrisch der Menge des abzutragenden Metalles entspricht. Hierbei besteht jedoch die Gefahr, daß bei zu knapper Dosierung des Oxidationsmittels keine vollständige Ätzung erfolgt, und daß andererseits bei schon geringem Überschuß an Oxidationsmittel doch wieder die unerwünschten, mit dem Vorhandensein des Oxidationsmittels in der Ätzlösung verbundenen Schwierigkeiten auftreten.

Aufgabe der vorliegenden Erfindung ist es, ein Verfahren der eingangs genannten Art anzugeben, bei dem mit Sicherheit eine vollständige Ätzung des Ätzgutes erhalten wird und gleichwohl die störenden Wirkungen des Oxidationsmittels im Ätzmittel vermieden werden.

Diese Aufgabe wird erfindungsgemäß dadurch gelöst, daß geringfügig mehr Oxidationsmittel zugegeben wird, als stöchiometrisch exakt der Menge des abzutragenden Metalles entspricht, und daß dem vom Ätzgut abgelaufenen Ätzmittel das nach der Ätzreaktion verbliebene Oxidationsmittel dadurch entzogen wird, daß dieses Ätzmittel über einen Überschuß an ätzbarem Metall geleitet wird.

Erfindungsgemäß wird also durch einen stöchiometrischen Überschuß an Oxidationsmittel zunächst sichergestellt, daß die Ätzung des Ätzgutes tatsächlich vollständig erfolgen kann. Dieser Oxidationsmittel-Überschuß wird selbstverständlich so niedrig wie möglich gehalten; er wird aus dem Ätzmittel dann dadurch wieder entfernt, daß letzterem durch einen Überschuß an ätzbarem Metall, welches sich und das Oxidationsmittel verbraucht, die Reaktionsfähigkeit vollständig entzogen wird. Auf diese Weise bleibt die Arbeitsfähigkeit der Umwälzpumpen voll erhalten; der Betrieb einer elektrolytischen Regenerationsanlage für das Ätzmittel ist nicht durch restliches Oxidationsmittel gefährdet.

Vorzugsweise ist das Material, aus dem der Überschuß an ätzbarem Metall besteht, dasselbe Metall, aus welchem zumindest teilweise das Ätzgut besteht. Hierdurch wird die Aufbereitung und Regeneration des Ätzmittels erheblich erleichtert.

Als Oxidationsmittel kommen vorzugsweise Wasserstoffperoxid oder auch Ozon in Frage.

Aufgabe der vorliegenden Erfindung ist es ferner, eine Vorrichtung der eingangs genannten Art derart auszugestalten, daß eine zuverlässige, vollständige Ätzung des Ätzgutes erfolgt, gleichzeitig aber Störungen im Betrieb der Umwälzpumpen und/oder der elektrolytischen Regenerationsanlage für das Ätzmittel vermieden sind.

Diese Aufgabe wird erfindungsgemäß dadurch gelöst, daß die die Zugabe des Oxidationsmittels regelnde Einrichtung so beschaffen ist, daß das Oxidationsmittel in größeren Mengen zugegeben wird, als es stöchiometrisch der Menge des abzutragenden Metalles entspricht, und daß mindestens eine Einrichtung vorgesehen ist, welcher aus dem Ätzmittelsumpf der Ätzmaschine restliches Oxidationsmittel enthaltendes Ätzmittel zugeführt wird und in der ein Überschuß an ätzbarem Metall mit dem Ätzmittel beaufschlagt wird.

Aus den bereits oben erläuterten Gründen ist es vorteilhaft, wenn das Material, aus dem der Überschuß an ätzbarem Metall besteht, dasselbe Metall ist, aus welchem zumindest teilweise das Ätzgut besteht.

Bei der Einrichtung, in der ein Überschuß an ätzbarem Material mit dem restliches Oxidationsmittel enthaltenden Ätzmittel beaufschlagt wird, kann es sich um einen ätzmaschinenähnlichen Vorätz-Baustein handeln, dessen Sumpf in Verbindung mit dem Sumpf der Ätzmaschine steht und welcher der Ätzmaschine vorgeschaltet ist, wobei in dem Vorätz-Baustein dem Ätzmittel kein Oxidationsmittel zugesetzt wird. Auf diese Weise wird der Überschuß an ätzbarem Metall durch das Metall des Ätzgutes selbst gebildet, welches in dem Vorätz-Baustein noch in großer Menge verfügbar ist. Auf diese Weise ergibt sich außerdem von selbst, daß der Überschuß an ätzbarem Metall und das abzuätzende Metall chemisch übereinstimmen.

Alternativ kann als Einrichtung, in der ein Überschuß an ätzbarem Material mit dem restliches Oxidationsmittel enthaltenden Ätzmittel beaufschlagt wird, einfach ein mit feinen Metallteilchen gefüllter Behälter sein.

In jedem Falle ist es zum Schutze der besonders empfindlichen Elektrolysezelle von Regenerationsanlagen von Vorteil, wenn die Einrichtung, in der ein Überschuß an ätzbarem Material mit dem restliches Oxidationsmittel enthaltenden Ätzmittel beaufschlagt wird, in der Zuführleitung zur Elektrolysezelle angeordnet ist.

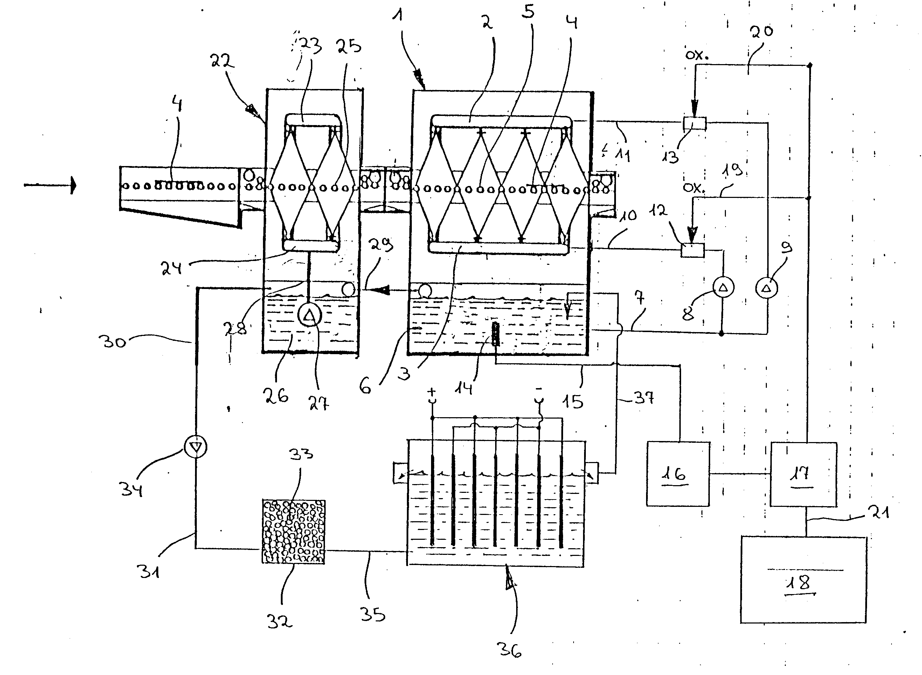

Ein Ausführungsbeispiel der Erfindung wird nachfolgend anhand der Zeichnung näher erläutert; die einzige Figur zeigt schematisch eine Ätzanlage mit elektrolytischer Regeneration des Ätzmittels.

In der Zeichnung ist mit 1 die eigentliche Ätzmaschine gekennzeichnet, die einen oberen, eine Vielzahl von Düsen aufweisenden Düsenstock 2 und einen unteren, ebenfalls eine Vielzahl von Düsen aufweisenden Düsenstock 3 besitzt. Das Ätzgut 4, beispielsweise eine mit Kupfer überzogene und entsprechend maskierte Leiterplatte, wird auf einer schematisch dargestellten Rollenbahn in der Zeichnung von links nach rechts durch die Ätzmaschine 1 geführt und dabei von oben und unten aus den Düsenstöcken 3 und 4 mit flüssigem, Schwefelsäure enthaltendem Ätzmittel besprüht.

Im unteren Bereich der Ätzmaschine 1 befindet sich ein Ätzmittelsumpf 6. Eine Entnahmeleitung 7 führt vom Ätzmittelsumpf 6 zur Saugseite zweier Pumpen 8 und 9, deren Auslaß über Leitungen 10 und 11 sowie über in den Leitungen 10 und 11 liegende Oxidationsmittel-Injektoren 12 und 13 mit den Düsenstöcken 3 bzw. 2 verbunden sind. Im Ätzmittelsumpf 6 der Ätzmaschine 1 befindet sich eine Sonde 14, die in geeigneter, bekannter Weise, z.B. elektrometrisch, die Konzentration des Oxidationsmittels im sich dort sammelnden Ätzmittel erfaßt. Die Sonde 14 ist über eine elektrische Leitung 15 mit einer Steuereinheit 16 verbunden, die ihrerseits eine Dosiereinrichtung 17 beaufschlagt. Die Dosiereinrichtung 17 entnimmt entsprechend den Signalen der Steuereinheit 16 über die Leitung 21 Oxidationsmittel aus einem Vorratstank 18 und führt dieses über die Leitungen 19, 20 den Injektoren 12, 13 zu.

Der Ätzmaschine 1 ist ein Vorätz-Baustein 22 vorgeschaltet, der also vor der Ätzmaschine 1 vom Ätzgut 4 durchlaufen wird. Der Vorätz-Baustein 22 ist als kleine Ätzmaschine gestaltet. Er umfaßt ebenfalls einen oberen Düsenstock 23, einen unteren Düsenstock 24, eine Rollenbahn 25 sowie im unteren Bereich einen Ätzmittelsumpf 26, in dem sich Schwefelsäure enthaltendes Ätzmittel sammelt.

Eine Pumpe 27 entnimmt Ätzmittel dem Ätzmittelsumpf 26 und führt dieses über eine Leitung 28 direkt den beiden Düsenstöcken 23 und 24 zu. Eine Möglichkeit zur Beimischung von Oxidationsmittel ist im Vorätz-Baustein 22 nicht vorgesehen.

Der Ätzmittelsumpf 26 des Vorätz-Bausteines 22 wird über eine Überlaufleitung 29 gespeist, welche den Ätzmittelsumpf 6 der Ätzmaschine 1 mit dem Ätzmittelsumpf 26 des Vorätz-Bausteines 27 verbindet.

Die Saugseite einer Pumpe 34 ist über eine Entnahmeleitung mit dem Ätzmittelsumpf 26 des Vorätz-Bausteines 22 verbunden. Der Auslaß der Pumpe 29 führt über eine Leitung 31 zu einem Behälter 32, der mit feinen, eine große Oberfläche darbietenden Metallteilchen 33 angefüllt ist. Bei dem Metall, aus dem diese Teilchen 33 bestehen, handelt es sich um dasselbe, das auch vom Ätzgut 4 abgeätzt wird.

Der Auslaß des Behälters 32 ist über eine Leitung 35 mit dem Einlaß einer Elektrolysezelle 36 verbunden, aus der regeneriertes Ätzmittel über eine Leitung 37 dem Ätzmittelsumpf 6 der Ätzmaschine 1 wieder zugeführt wird.

Die Funktionsweise der beschriebenen Ätzanlage ist wie folgt:

Im Gegensatz zu bekannten Ätzanlagen wird bei der Zugabe des Oxidationsmittels über die Injektoren 12, 13 zum Ätzmittel nicht angestrebt, genau diejenige Menge einzuhalten, die stöchiometrisch zum Abätzen der gesamten, vom Ätzgut abzutragenden Metallmenge erforderlich ist. Vielmehr wird über die Sonde 14, die entsprechend programmierte Steuereinheit 16 und die Dosiereinrichtung 17 für einen geringen, wenn auch kleinstmöglichen Oxidationsmittel-Überschuß gesorgt. Das Oxidationsmittel verbraucht sich also beim Ätzvorgang nicht vollständig sondern ist in geringen Mengen im Ätzmittelsumpf 6 nachweisbar. Damit es sich aber in dem Ätzmittelsumpf 6 nicht anreichert, was zu Schäden und Betriebsstörungen an den Pumpen 8, 9 und insbesondere an der Elektrolysezelle 36 führen würde, sind der Vorätz-Baustein 22 und der mit Metallteilchen 33 gefüllte Behälter 32 vorgesehen. Beide stellen Einrichtungen dar, mit denen restliches Oxidationsmittel aus dem Ätzmittel entfernt werden kann, welches dem Ätzmittelsumpf 6 der Ätzmaschine 1 entnommen wird. Dies geschieht dadurch, daß dem Oxidationsmittel ein Überschuß an Metall dargeboten wird, welches zum Teil unter Verbrauch des restlichen Oxidationsmittels abgeätzt wird. Im Falle des Vorätz-Bausteins 22 wird diese Funktion von dem Metall des Ätzguts 4 selbst, im Falle des Behälters 32 von den dort befindlichen Metallteilchen 33 übernommen.

In der Praxis ist es in vielen Fällen nicht erforderlich, sowohl einen Vorätz-Baustein 22 als auch einen metallgefüllten Behälter 32 vorzusehen. Vielmehr reicht häufig eine dieser Einrichtungen völlig aus, die vorzugsweise in die Zuführleitung 31, 35 der vor Oxidationsmittel besonders zu schützenden Elektrolysezelle 36 eingesetzt wird.

Im übrigen verläuft die elektrolytische Regeneration des Ätzmittels in der Elektrolysezelle 36 in bekannter Weise und braucht hier nicht weiter beschrieben zu werden. Vorzugsweise werden hierbei bipolare Elektroden eingesetzt.

Der Begriff des "Ätzens" wurde vorstehend in einer Weise verwendet, die nicht nur das vollständige Durchätzen einer Metallschicht sondern auch das Anätzen eines Metalles bis zu einer bestimmten Tiefe beinhaltet.

## Ansprüche

1. Verfahren zum Ätzen eines zumindest teilweise aus Metall, vorzugsweise aus Kupfer, bestehenden Ätzguts, vorzugsweise von gedruckten Leiterplatten, mit einem eine Säure, vorzugsweise Schwefelsäure, enthaltenden Ätzmittel, welchem kurz vor dem eigentlichen Ätzvorgang eine bestimmte Menge Oxidationsmittel zugesetzt wird, die in stöchiometrischer Beziehung zur Menge des abzuätzenden Metalles steht, dadurch gekennzeichnet, daß geringfügig mehr Oxidationsmittel zugegeben wird, als stöchiometrisch exakt der Menge des abzutragenden Metalles entspricht, und daß dem vom Ätzgut abgelaufenen Ätzmittel das nach der Ätzreaktion verbliebene Oxidationsmittel dadurch entzogen wird, daß dieses Ätzmittel über einen Überschuß an ätzbarem Metall geleitet wird.

2. Verfahren nach Anspruch 1, dadurch gekennzeichnet, daß das Material, aus dem der Überschuß an ätzbarem Metall besteht, dasselbe Metall ist, aus welchem zumindest teilweise das Ätzgut besteht.

3. Verfahren nach Anspruch 1 oder 2, dadurch gekennzeichnet, daß das Oxidationsmittel Wasserstoffperoxid ist.

4. Verfahren nach Anspruch 1 oder 2, dadurch gekennzeichnet, daß das Oxidationsmittel Ozon ist.

5. Vorrichtung zur Durchführung des Verfahrens nach Anspruch 1, mit einer Ätzmaschine, welche eine Vielzahl von Düsen und einen Ätzmittelsumpf umfaßt, mit einer Pumpe, welche dem Ätzmittelsumpf Ätzmittel entnimmt und den Düsen über eine Einrichtung zuführt, in welcher dem Ätzmittel ein Oxidationsmittel beigemischt wird, mit einer Einrichtung, welche die Zugabe des Oxidationsmittels zum Ätzmittel in stöchiometrischer Abhängigkeit von der Menge des abzuätzenden Metalles regelt, dadurch gekennzeichnet, daß die die Zugabe des Oxidationsmittels regelnde Einrichtung (12 bis 20) so beschaffen ist, daß das Oxidationsmittel in größerer Menge zugegeben wird, als es stöchiometrisch der Menge des abzuätzenden Metalles entspricht, und daß mindestens eine Einrichtung (22, 32) vorgesehen ist, welcher aus dem Ätzmittelsumpf (6) der Ätzmaschine (1) restliches Oxidationsmittel enthaltendes Ätzmittel zugeführt wird und in der ein Überschuß an ätzbarem Metall (4, 33) mit dem Ätzmittel beaufschlagt wird.

6. Vorrichtung nach Anspruch 5, dadurch gekennzeichnet, daß das Material, aus dem der Überschuß an ätzbarem Metall besteht, dasselbe Metall ist, aus welchem zumindest teilweise das Ätzgut besteht.

7. Vorrichtung nach Anspruch 5 oder 6, dadurch gekennzeichnet, daß die Einrichtung, in der ein Überschuß an ätzbarem Material mit dem restliches Oxidationsmittel enthaltenden Ätzmittel beaufschlagt wird, ein ätzmaschinenähnlicher Vorätz-Baustein (22) ist, dessen Sumpf (26) in Verbindung mit dem Sumpf (6) der Ätzmaschine (1) steht und welcher der Ätzmaschine (1) vorgeschaltet ist, wobei in dem Vorätz-Baustein (22) dem Ätzmittel kein Oxidationsmittel zugesetzt wird.

8. Vorrichtung nach Anspruch 5 oder 6, dadurch gekennzeichnet, daß die Einrichtung, in der ein Überschuß an ätzbarem Material mit dem restliches Oxidationsmittel enthaltenden Ätzmittel beaufschlagt wird, ein mit feinen Metallteilchen - (33) gefüllter Behälter (32) ist.

9. Vorrichtung nach einem der Ansprüche 5 bis 8, bei welcher eine Regeneration des Ätzmittels durch eine Elektrolysezelle erfolgt, die in Verbindung mit dem Sumpf der Ätzmaschine steht, dadurch gekennzeichnet, daß die Einrichtung (22, 32), in der ein Überschuß an ätzbarem Material mit dem restliches Oxidationsmittel enthaltenden Ätzmittel beaufschlagt wird, in der Zuführleitung - (30, 31, 35) zur Elektrolysezelle (36) angeordnet ist.

10. Vorrichtung nach einem der Ansprüche 5 bis 9, dadurch gekennzeichnet, daß die Elektroden der Elektrolysezelle (36) bipolare Elektroden sind.